# EUROPÄISCHE PATENTANMELDUNG

(11) **EP 4 672 610 A1**
(43) Veröffentlichungstag der Anmeldung: **31.12.2025**
(21) Anmeldenummer: 25184424.7
(22) Anmeldetag: 23.06.2025
(51) Int. Cl.: H03K 17/95, H05K 1/16, H03K 17/945, H01F 27/28

(54) **SPULENANORDNUNG AUF EINER MULTILAYER-PLATINE UND VERFAHREN ZUM HERSTELLEN EINER SPULENANORDNUNG**

(30) Priorität: 26.06.2024 DE 102024117999
(71) Anmelder: Turck Holding GmbH, 58553 Halver (DE)
(72) Erfinder: Faber, Michael, 58762 Altena (DE)
(74) Vertreter: DTS Patent- und Rechtsanwälte PartmbB

(57) **Zusammenfassung**

Die vorliegende Erfindung betrifft eine Multilayer-Platine (1) mit einer Spulenanordnung (10), insbesondere für einen induktiven Lagesensor (22); die Spulenanordnung (10) umfassend eine erste Spule (16) mit zumindest zwei Windungen, wobei die Windungen der ersten Spule (16) in separaten Lagen der Multilayer-Platine (1) übereinander angeordnet sind und einen gemeinsamen ersten Durchmesser (D1) aufweisen; und eine zweite Spule (14) mit zumindest zwei Windungen, wobei die Windungen der zweiten Spule (14) in separaten Lagen der Multilayer-Platine (1) übereinander angeordnet sind und einen gemeinsamen zweiten Durchmesser (D2) aufweisen; wobei die Windungen der ersten Spule (16) und die Windungen der zweiten Spule (14) zumindest teilweise in den gleichen Lagen der Multilayer-Platine (1) angeordnet sind; wobei sämtliche Windungen der ersten Spule (16) im Wesentlichen vollständig in jeweils einer Lage der Multilayer-Platine (1) ausgebildet sind; und wobei sämtliche Windungen der zweiten Spule (14) im Wesentlichen vollständig in jeweils einer Lage der Multilayer-Platine (1) ausgebildet sind. Die Erfindung betrifft ferner ein Verfahren zum Herstellen einer Spulenanordnung (10), insbesondere für einen induktiven Lagesensor (22).

## Beschreibung

Die vorliegende Erfindung betrifft eine Multilayer-Platine mit einer Spulenanordnung sowie ein Verfahren zum Herstellen einer Spulenanordnung.

Die Erfindung betrifft die Gebiete der Spulentechnologie und der Sensorik, beispielsweise der induktiven Näherungsschalter oder Lagesensoren.

Spulen werden in einer Vielzahl verschiedener Anwendungen genutzt, beispielsweise für induktive Sensoren. Sie werden dabei für die Aussendung und Auswertung elektromagnetischer Felder eingesetzt. Spulen können auf verschiedene Weisen gefertigt werden, etwa durch Wickeln von Kupferdraht oder in einer Leiterplattentechnik mit gedruckten Kupferleiterbahnen. Dabei können für Spulen in Leiterplattentechnik eine höhere Reproduzierbarkeit, eine vielfältige Designvarianz, eine besonders gute Wirtschaftlichkeit und eine höhere Langzeitstabilität erhalten werden.

Bei bekannten gedruckten Spulen werden die Windungen mit unterschiedlichen Durchmessern ausgeführt, etwa mit einem spiralförmigen Verlauf der gedruckten Leiterbahnen. Alternativ werden gewickelte Spulen als Lagenspulen vorgesehen, wobei dann die verwendete Wickeltechnik ganz wesentlich die Eigenschaften der Spulengüte und die Ausbreitung des elektromagnetischen Feldes bestimmt. Bei gewickelten Spulen stellen sich jedoch Herausforderungen durch eine schwierige Reproduzierbarkeit, hohe Kosten und ein großer Aufwand bei der weiteren Verarbeitung der Spulen in folgenden Fertigungsprozessen.

In der US 2008/0272982 A1 wird eine Hochimpedanzoberfläche mit eingebetteten Elementen wie Kondensatoren und Induktivitäten beschrieben, welche eine Antennenleistung verbessern und Störungen reduzieren soll. Die Hochimpedanzoberfläche kann zum Beispiel in die Nähe der Antenne gebracht werden. Die eingebetteten Elemente sollen dann die Ausbreitung von Oberflächenwellen minimieren und gleichzeitig den Impedanzabgleich verbessern, um so den Energieverbrauch zu reduzieren und die Bandbreite zu erhöhen.

Aus der US 2005/0195060 A1 ist es bekannt, Windungen mithilfe einer mehrlagigen Leiterplatte aufzubauen. Es werden Leiterbahnen auf verschiedenen Isolationsschichten der PCB angeordnet, die durch zusätzliche leitfähige Metallschichten ergänzt werden, um eine Wicklung zu bilden, die höhere Ströme effizienter verarbeiten kann.

Die US 2011/0253310 A1 schlägt eine Vorrichtung für eine Anordnung von induktionsspulen in einem Plasma-Verarbeitungssystem vor. Spulen werden auf separate Leiterplatten ausgebildet, die übereinander angeordnet sind. Jede PCB-Ebene enthält eine Spulenanordnung, die kreisförmig ineinander verschlungene, nicht-kreisförmige Spulen umfasst. Die mehrschichtig angeordneten Spulen können unabhängig voneinander betrieben werden, um die Plasmadichte in radialer Richtung zu optimieren und eine verbesserte Plasmauniformität zu erreichen.

Es ist die Aufgabe der vorliegenden Erfindung, eine Spulenanordnung bereitzustellen, die es erlaubt, die Vorteile von gewickelten und gedruckten Spulen zu verbinden, und die darüber hinaus eine einfache und gut reproduzierbare Fertigung ermöglicht.

Diese Aufgabe wird erfindungsgemäß gelöst durch eine Spulenanordnung mit den Merkmalen des Anspruchs 1 sowie ein Verfahren mit den Merkmalen des unabhängigen Verfahrensanspruchs. Vorteilhafte Ausgestaltungen sind in den Unteransprüchen angegeben.

Danach wird die Aufgabe gelöst durch eine Multilayer-Platine mit einer Spulenanordnung, insbesondere für einen induktiven Lagesensor. Dabei umfasst die Spulenanordnung eine erste Spule mit zumindest zwei Windungen, wobei die Windungen der ersten Spule in separaten Lagen der Multilayer-Platine übereinander angeordnet sind und einen gemeinsamen ersten Durchmesser aufweisen. Die Spulenanordnung umfasst ferner eine zweite Spule mit zumindest zwei Windungen. Dabei sind die Windungen der zweiten Spule in separaten Lagen der Multilayer-Platine übereinander angeordnet sind und sie weisen einen gemeinsamen zweiten Durchmesser auf. Dabei sind die Windungen der ersten Spule und die Windungen der zweiten Spule zumindest teilweise in den gleichen Lagen der Multilayer-Platine angeordnet.

Insbesondere sind sämtliche Windungen der ersten Spule im Wesentlichen vollständig in jeweils einer Lage der Multilayer-Platine ausgebildet und sämtliche Windungen der zweiten Spule sind im Wesentlichen vollständig in jeweils einer Lage der Multilayer-Platine ausgebildet.

Unter einer "Multilayer-Platine" (auch: Multilayer-PCB, Mehrlagenplatine) wird vorliegend insbesondere eine Leiterplatte verstanden, die aus zumindest zwei oder mehr leitfähigen Schichten besteht, die durch ein isolierendes Material voneinander getrennt sind. Diese Schichten können beispielsweise unter Hitze und Druck zusammenlaminiert sein. Die leitfähigen Schichten können insbesondere auch als "Lagen" oder auch "Cu-Lagen" bezeichnet werden.

Unter einer "Lage" einer Multilayer-Platine kann in der vorliegenden Beschreibung beispielsweise eine einzelne Schicht der Multilayer-Platine verstanden werden, wobei auf der Lage Leiterbahnen und andere Elemente aufgebracht werden können. Insbesondere kann, wie oben erläutert, eine "Lage" im Sinne der vorliegenden Beschreibung eine Schicht eines isolierenden Trägermaterials umfassen, auf welcher leitfähige Elemente und weitere Elemente aufgebracht werden können.

Unter einer "Windung" einer Spule können beispielsweise einzelne Schleifen oder Umdrehungen einer aus leitfähigem Material gebildeten Leiterbahn verstanden werden. Die erste und zweite Spule weisen bei der Spulenanordnung zumindest zwei Windungen auf.

Eine Windung kann dabei rund ausgebildet sein oder sie kann eine andre Geometrie aufweisen, etwa bei einer polygonalen Spulenform. Alle Windungen einer Spule können mit der gleichen Geometrie ausgebildet sein und beispielsweise alle kreisrund oder polygonal verlaufen.

Vorliegend wird ferner von einer "vollständigen" Windung ausgegangen, wenn die Windung eine im Wesentlichen geschlossene Bahn aufweist. Eine in diesem Sinne vollständige Windung kann beispielsweise eine fast geschlossene Kreisbahn aufweisen, wobei zu beachten ist, dass aus technischen Gründen die Bahn der Windung nicht geschlossen sein darf, da die Windung sonst kurzgeschlossen würde. Bei einer vollständigen Windung in einer Lage der Multilayer-Platine können beispielsweise ein Anfangspunkt und ein Endpunkt einer durchgehenden Leiterbahn nahe beieinander liegen, sodass die Leiterbahn eine fast vollständige geschlossene Bahn beschreibt.

Insbesondere ist dabei die erste Spule als Sendespule und die zweite Spule als Empfangsspule eines induktiven Lage- beziehungsweise Näherungssensors ausgebildet.

Bei der Spulenanordnung weisen die Windungen der ersten Spule einen gemeinsamen ersten Durchmesser auf und die Windungen der zweiten Spule weisen einen gemeinsamen zweiten Durchmesser auf.

Insbesondere weisen die erste und zweite Spule ferner eine gemeinsame Längsachse auf.

Die Windungen sind insbesondere so ausgebildet, dass sie einen wohldefinierten Durchmesser aufweisen. Beispielsweise können die Windungen entlang eines Kreises mit einem bestimmten Durchmesser ausgebildet sein, wobei eine vollständige Windung entlang eines bis auf einen schmalen Spalt geschlossenen Kreises ausgebildet ist. Ein Durchmesser einer Windung kann auch definiert sein, wenn die Windung zum Beispiel einer polygonalen Form folgt; in diesem Fall kann der Durchmesser eines Inkreises oder eines Umkreises als Durchmesser betrachtet werden.

Insbesondere weisen die erste und die zweite Spule jeweils mehrere Windungen auf, wobei alle Windungen einer Spule mit jeweils im Wesentlichen dem gleichen, identischen Durchmesser und einem Mittelpunkt auf einer gemeinsamen Längsachse ausgebildet sind. Insbesondere können die erste und/oder die zweite Spule zylindrisch ausgebildet sein, wobei die Windungen im Wesentlichen entlang jeweils einer gedachten Zylindermantelfläche angeordnet sind.

Die Ausbildung der Spulen erlaubt es, auf der Multilayer-Platine eine praktisch zylinderförmige Spulenform auszubilden, insbesondere für gedruckte Spulen. Insbesondere sind die erste und zweite Spule als Zylinderspulen ausgebildet.

Die Windungen einer Spule können so ausgebildet sein, dass sie bei einer Draufsicht aus Richtung ihrer Längsachse übereinanderliegen beziehungsweise praktisch deckungsgleich ausgebildet sind. Die erste und die zweite Spule können dann so ausgebildet sein, dass ihre Windungen jeweils so übereinander angeordnet sind, dass sie bei einer Draufsicht auf die Multilayer-Platine beziehungsweise bei einer entsprechenden Projektion entlang einer Längsachse der Spulen senkrecht zur Ebene der Multilayer-Platine direkt übereinander liegen.

Insbesondere kann das Merkmal, dass die Windungen in den Lagen der Multilayer-Platine übereinander angeordnet sind, so verstanden werden, dass sie im Wesentlichen deckungsgleich sind in einer Projektion entlang der Längsachse der Spule.

Die Windungen der ersten und der zweiten Spule sind zumindest teilweise in den gleichen Lagen der Multilayer-Platine angeordnet. Bei Zylinderspulen mit der gleichen Längsachse muss folglich eine der Zylinderspulen einen kleineren Durchmesser aufweisen als die andere.

Bei einer Ausbildung sind die erste und die zweite Spule als Zylinderspulen mit einer gemeinsamen Längsachse ausgebildet, wobei sich die Erstreckung der ersten und zweiten Spule in Längsrichtung überlappen, sodass eine Spule zumindest teilweise innerhalb der anderen Spule angeordnet ist.

Falls die Spulenanordnung eine dritte Spule umfasst, die ebenfalls als Zylinderspule ausgebildet ist und die gleiche Längsachse aufweist wie die erste und die zweite Zylinderspule, kann diese den gleichen Durchmesser wie eine der anderen Spulen aufweisen.

Diese Ausbildung der Spulen unterscheidet sich von typischen Spulen in bekannten Spulenanordnungen, die auf Platinen ausgebildet sind: Dort werden die Windungen üblicherweise spiralförmig ausgebildet, sodass die einzelnen Windungen keinen definierten Durchmesser im Sinne der vorliegenden Beschreibung aufweisen beziehungsweise sodass die einzelnen Windungen einer Spule keinen gemeinsamen Durchmesser haben.

Die Windungen der Spulen können dabei ferner so ausgebildet sein, dass sie alle die gleiche Größe und Form aufweisen. Beispielsweise können die Windungen rund ausgebildet sein und dabei den gleichen Durchmesser sowie den gleichen Mittelpunkt in der Ebene der Multilayer-Platine aufweisen. Die Windungen können ferner eine andere Geometrie aufweisen, etwa als Polygone, wobei sie dann optional deckungsgleich zueinander ausgebildet sein können oder in den verschiedenen Lagen um einen bestimmten Winkel relativ zueinander rotiert ausgebildet sein können.

Beispielsweise können die Windungen einer Spule jeweils in aufeinander folgenden "Kupfer-Lagen" angeordnet sein, wobei zwischen den Kupfer-Lagen jeweils eine Isolationsschicht angeordnet ist. Die Kupfer-Lagen sind dabei solche Lagen der Multilayer-Platine, in denen aus einem elektrisch leitenden Material wie beispielsweise Kupfer die elektrische leitfähigen Windungen der Spulen ausgebildet sind. In den Isolationsschichten können insbesondere zusätzliche leitfähige Bereiche vorgesehen sein, insbesondere zur Kontaktierung der Windungen und weiterer Elemente in den ansonsten voneinander isolierten weiteren Lagen.

Wenigstens eine oder einige der Windungen der ersten Spule sind in der gleichen Lage der Multilayer-Platine angeordnet wie wenigstens eine Windung der zweiten Spule. Das heißt, die jeweilige Längserstreckung der ersten beziehungsweise der zweiten Spule in Richtung ihrer Längsachse (beziehungsweise ihrer Mittelachse) überschneidet sich.

Eine Anordnung der Windungen entlang einer gemeinsamen Längsachse bedeutet insbesondere, dass die erste und die zweite Spule sowie gegebenenfalls weitere Spulen der Spulenanordnung bei einer Projektion in der Ebene der Multilayer-Platine den gleichen Mittelpunkt aufweisen.

Insbesondere sind der erste und der zweite Durchmesser der ersten beziehungsweise zweiten Spule unterschiedlich groß, sodass in wenigstens einer Lage der Multilayer-Platine eine Windung der ersten Spule von einer Windung der zweiten Spule umschlossen ist oder umgekehrt.

Der Durchmesser und gegebenenfalls der Mittelpunkt ist bei einer kreisförmigen Form einer Windung nach üblichen geometrischen Überlegungen definiert.

Die Windungen können darüber hinaus auf andere Weise ausgebildet sein, beispielsweise polygonal. Der Durchmesser und der Mittelpunkt können dann auf an sich bekannte Weise definiert sein, etwa anhand des Umkreises des Polygons.

Bei einer weiteren Ausbildung umfasst die Spulenanordnung ferner eine dritte Spule mit zumindest zwei Windungen, die in separaten Lagen der Multilayer-Platine übereinander angeordnet sind. Die Windungen der dritten Spule weisen insbesondere einen gemeinsamen dritten Durchmesser auf. Dabei sind die Windungen der dritten Spule und die Windungen der ersten und/oder zweiten Spule zumindest teilweise in den gleichen Lagen der Multilayer-Platine angeordnet. Insbesondere sind sämtliche Windungen der dritten Spule im Wesentlichen vollständig in jeweils einer Lage der Multilayer-Platine ausgebildet.

Die dritte Spule kann beispielsweise als eine weitere Empfangsspule eines Lagenbeziehungsweise Näherungssensors ausgebildet sein.

Zum Beispiel kann ein induktiver Faktor-1 Sensor bereitgestellt werden, indem drei layoutete Lagenspulen auf einer Multilayer-Platine kombiniert werden. Eine der Spulen wird als Sendespule verwendet und zwei weitere Spulen dienen als Empfangsspulen, deren Signale um 180° phasenverschoben sind.

Die dritte Spule kann ferner analog zur ersten und/oder zweiten Spule ausgebildet sein, allerdings insbesondere mit einem dritten Durchmesser für alle Windungen, der sich vom ersten und zweiten Durchmesser der ersten beziehungsweise zweiten Spule unterscheidet.

Insbesondere können die Windungen der dritten Spule gleich groß und gleich geformt sein und genau übereinander angeordnet sein.

Die Windungen der dritten Spule können ferner - wie auch die Windungen der ersten und/oder zweiten Spule - in zueinander benachbarten Kupfer-Lagen der Multilayer-Platine ausgebildet sein.

Wenigstens eine oder einige der Windungen der dritten Spule sind in der gleichen Lage der Multilayer-Platine angeordnet wie wenigstens eine Windung der ersten und/oder zweiten Spule. In diesem Fall überschneidet sich daher die Längserstreckung der dritten Spule in Richtung ihrer Längsachse (beziehungsweise ihrer Mittelachse) mit der Längserstreckung der ersten und/oder zweiten Spule.

Ferner kann vorgesehen sein, dass in wenigstens einer Lage der Multilayer-Platine Windungen der ersten, zweiten und dritten Spule angeordnet sind. Diese Windungen haben insbesondere den gleichen Mittelpunkt und unterschiedliche Durchmesser, sodass sie einander umgeben.

Beispielsweise kann die erste Spule, die insbesondere als Sendespule eines Lage- beziehungsweise Näherungssensors ausgebildet ist, einen Durchmesser aufweisen, der zwischen dem zweiten und dritten Durchmesser der zweiten beziehungsweise dritten Spule liegt, welche insbesondere als Empfangsspulen des Sensors ausgebildet sind. In diesem Fall ist also die erste Spule zwischen der zweiten Spule und der dritten Spule angeordnet, die einerseits einen größeren und andererseits einen kleineren Durchmesser aufweisen.

Bei einer Weiterbildung sind die erste, zweite und/oder gegebenenfalls dritte Spule so ausgebildet, dass die aufeinander folgenden Windungen einer Spule in jeweils aufeinander folgenden Schichten der Multilayer-Platine ausgebildet sind.

Insbesondere sind sämtliche Windungen der ersten, zweiten und/oder gegebenenfalls der dritten Spule jeweils in verschiedenen Lagen, insbesondere in aufeinander folgenden Lagen angeordnet.

Die Spulen weisen also insbesondere keine spiralförmigen Windungen in einer einzigen Ebene auf, wie dies bei gedruckten Spulen typischerweise vorgesehene ist, sondern die Windungen sind auf mehrere, insbesondere benachbarte, Kupfer-Lagen der Multilayer-Platine verteilt.

Die Kontaktierung der Windungen einer Spule erfolgt auf an sich bekannte Weise durch die zwischen aufeinander folgenden Lagen angeordneten Isolationsschichten hindurch.

Bei einer Ausbildung sind sämtliche Windungen der ersten, zweiten und/oder gegebenenfalls der dritten Spule als jeweils im Wesentlichen vollständige Windungen in jeweils einer Lage der Multilayer-Platine ausgebildet.

Insbesondere sind die Windungen der ersten, zweiten und/oder gegebenenfalls der dritten Spule in den jeweiligen verschiedenen Lagen als im Wesentlichen vollständige Windungen ausgebildet.

Als "vollständig" wird dabei insbesondere eine Windung verstanden, die in einer Ebene eine im Wesentlichen geschlossene Bahn beschreibt. Aus technischen Gründen, nämlich um einen Kurzschluss zu vermeiden, sind die Windungen nicht vollständig geschlossen, aber sie können mit einem kleinen Spalt beziehungsweise einem geringen Versatz zwischen dem Startpunkt und dem Endpunkt der Windung in einer Ebene ausgebildet sein.

Insbesondere ist vorgesehen, dass die Windungen nicht über mehrere Lagen der Multilayer-Platine verteilt sind, etwa indem die Windungen in Kreissegmente aufgeteilt sind, die auf verschiedenen Lagen angeordnet sind und nur zusammen vollständige Windungen bilden.

Insbesondere wird vorliegend von "vollständigen" Windungen ausgegangen, wenn diese einen Verlauf des leitfähigen Materials um einen Winkel von im Wesentlichen 360° aufweisen, gemessen vom Mittelpunkt der Windung. Um die Windungen auf mehrere Lagen verteilen und miteinander kontaktieren zu können, werden die Windungen typischerweise nicht vollständig über 360° ausgebildet, sondern können beispielsweise eine "Öffnung" über einen Winkel von höchstens 45°, vorzugsweise höchstens 30°, weiter vorzugsweise höchstens 15°, aufweisen, gemessen vom Mittelpunkt der Windung.

Bei einer weiteren Ausbildung weist zumindest eine der ersten und/oder zweiten und/oder gegebenenfalls der dritten Spule eine polygonale Geometrie auf.

Die Geometrie der Windungen kann insbesondere quadratisch oder rautenförmig sein.

Insbesondere kann die Spulenanordnung für einen Einbau in ein Gehäuse optimiert sein, etwa durch Anpassen der Geometrie der Spulen an die Form des Querschnitts des Gehäuses. Dies ist dann besonders relevant, wenn das Gehäuse Metall umfasst, welches die Sende- und/oder Empfangseigenschaften der Spulen stören kann.

Beispielsweise kann die Spulengeometrie bei einem runden Gehäusequerschnitt für zumindest eine Spule quadratisch sein; insbesondere kann zumindest eine als Empfangsspule ausgebildete erste und/oder dritte Spule quadratisch ausgebildet sein; in diesem Fall wird die im Querschnitt des Gehäuses zur Verfügung stehende Fläche an den Ecken des Quadrats maximal ausgenutzt, während die Seiten des Quadrats vom Gehäuse entfernt angeordnet sind und daher von metallischem Material weniger gestört werden.

Ferner kann bei einem quadratischen oder rechteckige Gehäusequerschnitt vorgesehen sein, dass eine quadratische oder rechteckige Form zumindest einer der Spulen demgegenüber um 45° gedreht ist, sodass möglichst viele Abschnitte der Spule möglichst weit vom Gehäuse entfernt sind, wobei gleichzeitig die Eckpunkte der Wicklungsgeometrie die zur Verfügung stehende Fläche ausgenutzt.

Auch andere geometrische Formen der Spulen beziehungsweise der Windungen sind denkbar, insbesondere um sicherzustellen, dass diese nicht zu dicht an einem gegebenenfalls störenden Metallgehäuse angeordnet sind.

Bei einer Weiterbildung ist zumindest ein Teil der Windungen der ersten und zweiten Spule, sowie gegebenenfalls der dritten Spule, in überlappenden Lagen der Multilayer-Platine angeordnet. Dabei sind optional in zumindest einer Lage der Multilayer-Platine jeweils eine Windung aller Spulen angeordnet.

Insbesondere sind die Spulen wenigstens teilweise ineinander "geschachtelt" angeordnet. Das heißt, die Längserstreckungen der ersten, zweiten und gegebenenfalls dritten Spule überlappen sich in Richtung ihrer Längsachse (beziehungsweise ihrer Mittelachse).

Die vorliegend beschriebene Spulenanordnung ermöglicht vorteilhafterweise eine gute Reproduzierbarkeit, eine kostengünstige Herstellung für Massenprodukte, eine besonders große Designfreiheiten bei den Spulen-Geometrien, eine flexible Anzahl von Lagenspulen auf einer Multilayer-Platine sowie die Möglichkeit, ein komplettes Spulensystem für induktive Näherungsschalter oder Lagesensoren mit Faktor-1 Verhalten zu realisieren. Somit werden neue optimierte Aufbau- und Einbaueigenschaften eines Sensors mit gedruckten Spulensystemen ermöglicht.

Die Spulenanordnung erlaubt es, Leiterplattenspulen so auszubilden, dass sie im Wesentlichen die Eigenschaften einer gewickelte Lagenspule in einem Multilayer-Aufbau aufweisen. Zudem können in der Ausbildung der Spulen als Lagenspule auf einer Multilayer-Platine auch mehrere Spulen mit unterschiedlichen Durchmessern ausgeführt werden. Somit ist ein komplettes Faktor-1 Spulensystem auf einer Multilayer-Platine möglich.

Die Lagenspule auf einer Multilayer-Platine kann insbesondere realisiert werden, indem pro Kupferlayer eine Windung exakt geometrisch unter der jeweils vorherigen positioniert wird. Dadurch entsteht auf der Multilayer-Platine eine Lagenspule mit minimalen Abständen der Wicklungen zueinander.

Ein weiterer Vorteil besteht weiterhin, dass auf einer Multilayer-Platine mehrere Lagenspulen ausgebildet werden können. Zum Beispiel kann mit mindestens drei layouteten Lagenspulen ein komplettes Spulensystem für einen induktiven Faktor-1 Sensor auf einer Leiterplatte erstellt werden.

Der induktive Lagesensor umfasst eine Spulenanordnung gemäß der vorliegenden Beschreibung.

Dabei ist insbesondere die erste Spule der Spulenanordnung als Sendespule ausgebildet und die zweite Spule ist als Empfangsspule ausgebildet. Optional kann eine dritte Spule als weitere Empfangsspule ausgebildet sein. Es kann eine Steuereinheit des induktiven Lagesensors vorgesehen sein,

Der Lagesensor kann beispielsweise als Näherungssensor oder Näherungsschalter ausgebildet sein, der dazu eingerichtet ist, ein Zielobjekt, insbesondere ein metallisches Zielobjekt, in einem Erfassungsbereich zu erfassen und beispielsweise ein Signal in Abhängigkeit von dem erfassten Zielobjekt auszugeben, etwa ein Schaltsignal.

Hierzu kann eine Steuereinheit vorgesehen sein, welche die Spulenanordnung ansteuert.

Bei dem Verfahren zum Herstellen einer Spulenanordnung, insbesondere für einen induktiven Lagesensor, wird eine erste Spule mit zumindest zwei Windungen so erstellt, dass die Windungen der ersten Spule in separaten Lagen einer Multilayer-Platine übereinander angeordnet sind und einen gemeinsamen ersten Durchmesser aufweisen. Ferner es wird eine zweite Spule mit zumindest zwei Windungen so erstellt, dass die Windungen der zweiten Spule in separaten Lagen der Multilayer-Platine übereinander angeordnet sind und einen gemeinsamen zweiten Durchmesser aufweisen. Dabei sind die Windungen der ersten Spule und die Windungen der zweiten Spule zumindest teilweise in den gleichen Lagen der Multilayer-Platine angeordnet.

Insbesondere sind sämtliche Windungen der ersten Spule im Wesentlichen vollständig in jeweils einer Lage der Multilayer-Platine ausgebildet und sämtliche Windungen der zweiten Spule sind im Wesentlichen vollständig in jeweils einer Lage der Multilayer-Platine ausgebildet.

Dabei weisen die Windungen der ersten Spule einen gemeinsamen ersten Durchmesser auf und die Windungen der zweiten Spule weisen einen gemeinsamen zweiten Durchmesser auf. Dabei weisen die erste und zweite Spule ferner eine gemeinsame Längsachse auf.

Das Verfahren ist insbesondere dazu eingerichtet, eine Spulenanordnung nach der vorliegenden Beschreibung herzustellen. Es weist daher die gleichen Vorteile auf wie die Spulenanordnung und es kann in analoger Weise weitergebildet werden. Umgekehrt können die Vorteile und Weiterbildungen des Verfahrens in analoger Weise auf die Spulenanordnung übertragen werden.

Weitere Einzelheiten und Vorteile der Erfindung sollen nun anhand eines in den Zeichnungen dargestellten Ausführungsbeispiels näher erläutert werden.

Es zeigen:
- Fig. 1 (i) bis (xiv): eine schematische Darstellung der Lagen eines Ausführungsbeispiels der Multilayer-Platine mit einer Spulenanordnung in einer Draufsicht;
- Fig. 2: ein Ausführungsbeispiel eines induktiven Lagesensors mit der Spulenanordnung;
- Fig. 3: eine schematische Darstellung von drei Lagen der Multilayer-Platine in einer Seitenansicht; und
- Fig. 4: ein schematisches Flussdiagramm eines Ausführungsbeispiels des Verfahrens zum Herstellen der Multilayer-Platine mit der Spulenanordnung.

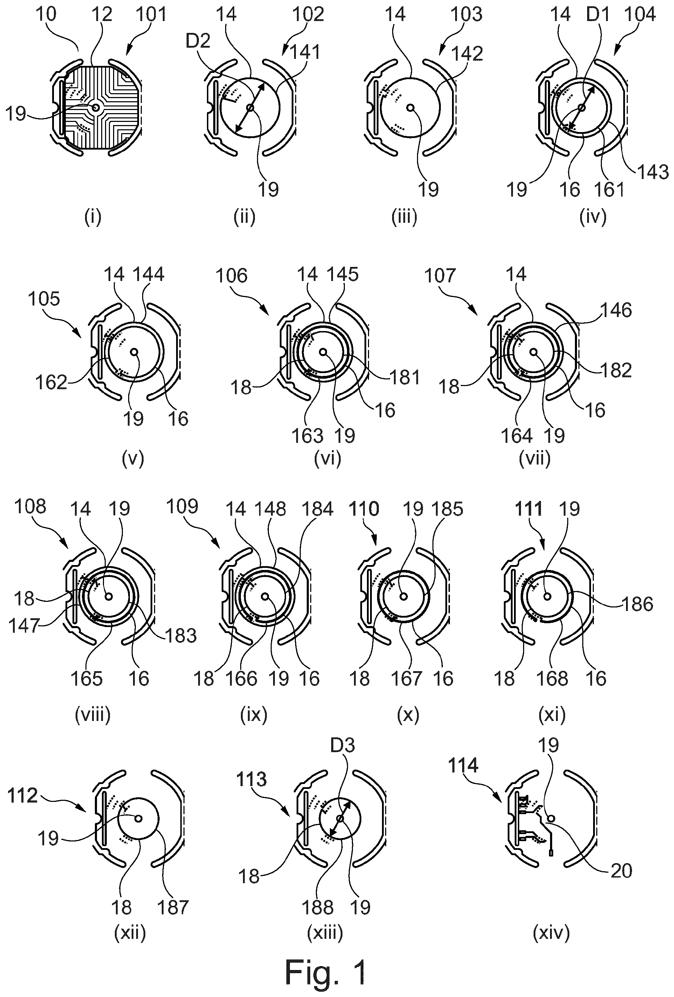

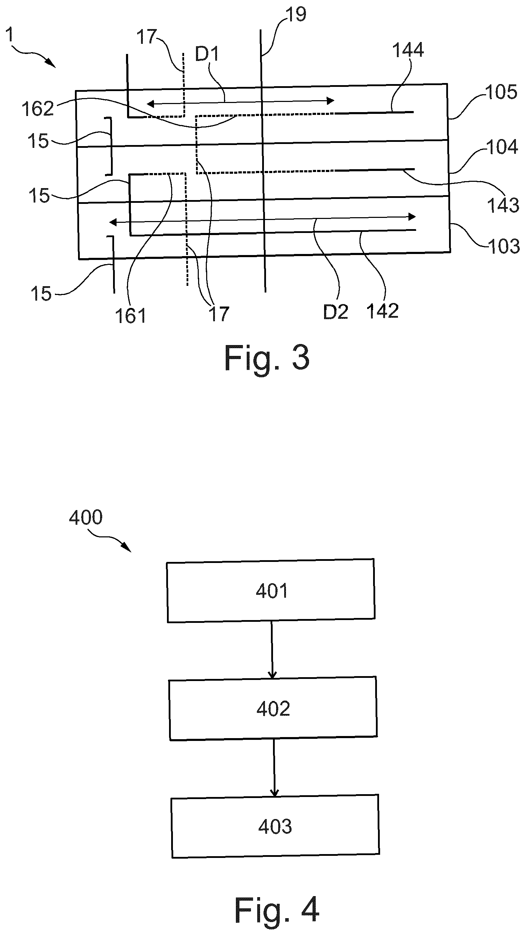

Mit Bezug zu den Fig. 1 (i) bis (xiv), 2 sowie 3 wird der Aufbau einer Multilayer-Platine mit einem Ausführungsbeispiel der Spulenanordnung erläutert. Die gezeigten Darstellungen des Aufbaus der Lagen 101 bis 114 der Multilayer-Platine 1 sind lediglich schematisch zu verstehen. In der Seitenansicht der Fig. 3 sind Teile der Spulen in den einzelnen Lagen der Multilayer-Platine gezeigt.

Die Spulenanordnung 10 weist bei dem Ausführungsbeispiel drei Spulen 14, 16, 18 auf.

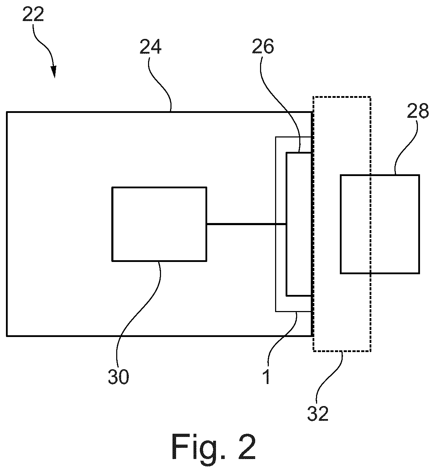

Die Spulenanordnung 10 ist dabei für den Einsatz in einem induktiven Lagesensor 22 ausgebildet, wie er unten mit Bezug zu Fig. 2 näher erläutert wird.

Eine erste Spule 16 ist dabei als Sendespule ausgebildet.

Eine zweite Spule 14 ist dabei als erste Empfangsspule ausgebildet. Sie weist bei dem Ausführungsbeispiel einen größeren Durchmesser gegenüber der ersten Spule 16 auf.

Eine dritte Spule 18 ist als zweite Empfangsspule ausgebildet. Sie weist bei dem Ausführungsbeispiel einen geringeren Durchmesser gegenüber der ersten Spule 16 auf.

Sämtliche Windungen 161, 162 der ersten Spule 16 weisen einen ersten gemeinsamen Durchmesser D1 auf.

Sämtliche Windungen 141, 142 der zweiten Spule 14 weisen einen zweiten gemeinsamen Durchmesser D2 auf.

Bei dem Beispiel ist der erste gemeinsame Durchmesser D1 kleiner als der zweite gemeinsame Durchmesser D2.

Sämtliche Windungen 181, 182 der dritten Spule 18 weisen einen dritten gemeinsamen Durchmesser D3 auf.

Bei dem Beispiel ist der dritte gemeinsame Durchmesser D3 kleiner als der erste D1 und der zweite gemeinsame Durchmesser D2.

Die erste 16, zweite 14 und dritte Spule 18 sind bei dem Beispiel konzentrisch um die gemeinsame Längsachse 19 angeordnet.

Wie in Fig. 1 erkennbar, ist jede der Windungen 141 bis 148, 161 bis 168, 181 bis 188 der ersten (16), zweiten (14) beziehungsweise dritten Spule (18) flach ausgebildet, das heißt, sie ist vollständig in einer einzigen Ebene ausgebildet, das heißt in nur einer Ebene, die vollständig in einer der Schichten 101 bis 114 der Multilayer-Platine 1 angeordnet ist.

Dies ist auch in Fig. 3 erkennbar, wo schematisch drei Schichten 103 bis 105 der Multilayer-Platine 1 in einer Ansicht von der Seite gezeigt sind. Obwohl hier nur drei Schichten 103 bis 105 und einige der Windungen 142 bis 144, 161, 162 der ersten 16 und zweiten Spule 14 gezeigt sind, ist die Beschreibung entsprechend anwendbar auf sämtliche Schichten 101 bis 114 der Multilayer-Platine 1 sowie auf die dritte Spule 18 und ihre Windungen 181 bis 188.

Wie in Fig. 3 erkennbar, sind die Windungen 142 bis 144, die mit durchgezogenen Linien gezeichnet sind, der zweiten Spule 14 vollständig in jeweils einer der Schichten 103 bis 105 ausgebildet, das heißt, eine zweite Windung 142 der zweiten Spule 14 ist vollständig in der dritten Lage 103 der Multilayer-Platine 1 ausgebildet, eine dritte Windung 143 der zweiten Spule 14 ist vollständig in der vierten Lage 104 Multilayer-Platine 1 ausgebildet und eine vierte Windung 144 der zweiten Spule 14 ist vollständig in der fünften Lage 105 Multilayer-Platine 1 ausgebildet.

Wie zudem in Fig. 3 erkennbar, sind die Windungen 161, 162, die gestrichelt gezeichnet sind, der ersten Spule 16 vollständig in jeweils einer der Schichten 104, 105 ausgebildet, das heißt, eine erste Windung 161 der ersten Spule 16 ist vollständig in der vierten Lage 104 Multilayer-Platine 1 ausgebildet und eine zweite Windung 162 der ersten Spule 16 ist vollständig in der fünften Lage 105 Multilayer-Platine 1 ausgebildet.

Die Windungen 141 bis 148 der zweiten Spule 14 sind durch Durchkontaktierungen 15 miteinander verbunden. Die Durchkontaktierungen 15 bilden dabei einen Teil der Multilayer-Platine 1. Die Durchkontaktierungen 15 erstrecken sich parallel zur Längsachse 19.

Die Windungen 161 bis 168 der ersten Spule 16 sind durch Durchkontaktierungen 17 miteinander verbunden, die mit gestrichelten Linien gezeichnet sind. Die Durchkontaktierungen 17 bilden dabei einen Teil der Multilayer-Platine 1. Die Durchkontaktierungen 17 erstrecken sich parallel zur Längsachse 19.

Die Windungen 181 bis 188 der dritten Spule 18 sind ebenfalls durch Durchkontaktierungen miteinander verbunden. Diese Durchkontaktierungen bilden dabei einen Teil der Multilayer-Platine 1. Sie erstrecken sich parallel zur Längsachse 19.

In der ersten dargestellten Lage (i) weist die Spulenanordnung 10 ein Abschirmgitter 12 auf. Dieses ist auf an sich bekannte Weise ausgebildet und ist insbesondere dazu eingerichtet, elektromagnetische Felder abzuschirmen.

Die Spulenanordnung 10 ist dazu eingerichtet, in ein Gehäuse des Lagesensors 22 so eingebaut zu werden, dass das Abschirmgitter 12 nach vorne ausgerichtet ist, das heißt insbesondere zur aktiven Frontfläche des Sensors hin, um hochfrequente Störungen von den Spulen 14, 16, 18 abzuschirmen, das heißt von der Richtung der gewünschten Erfassung weg.

Die Spulen 14, 16, 18 sind hier jeweils so ausgebildet, dass alle ihre kreisrund ausgebildeten Windungen jeweils den gleichen ersten D1, zweiten D2 beziehungsweise dritten Durchmesser D3 aufweisen und dass ihre Mittelpunkte entlang der gleichen Achse 19 angeordnet sind. Diese Achse 19 ist senkrecht zur Ebene beziehungsweise Oberfläche der Multilayer-Platine 1 angeordnet sowie zu den Lagen 101 bis 114 der Multilayer-Platine 1 und definiert daher eine gemeinsame Längsachse 19 für alle drei Spulen 14, 16, 18.

Die Spulen 14, 16, 18 sind daher im Wesentlichen analog zu zylindrischen Spulen ausgebildet, wobei ihre maximale Länge durch die Dicke der Multilayer-Platine 1 vorgegeben ist, gemessen in Richtung der Achse 19.

Bei dem Beispiel überlappen die Längsausdehnungen der Spulen 14, 16, 18, wobei in einzelnen Lagen der Multilayer-Platine teilweise Windungen der ersten 16 und zweiten Spule 14, der zweiten 14 und dritten Spule 18 oder aller drei Spulen 14, 16, 18 angeordnet sind. Zudem sind Lagen 101 bis 114 der Multilayer-Platine 1 vorgesehen, die lediglich eine Windung der zweiten 14 oder dritten Spule 18 aufweisen.

Bei dem Beispiel vom Abschirmgitter 12 ausgehend beginnt zunächst die zweite Spule 14 in ihrer Längserstreckung, dann beginnt die erste Spule 16 mit einem kleineren Durchmesser als die zweite Spule 14, dann beginnt die drittes Spule 18 mit einem noch kleineren Durchmesser. Anschließend endet die Längserstreckung der zweiten Spule 14, welche bis zu der als (ix) bezeichneten Lage reicht, dann endet die Längserstreckung der ersten Spule 16, welche bis zu der als (xi) bezeichneten Lage reicht, und dann endet die Längserstreckung der dritten Spule 18, welche bis zu der als (xiii) bezeichneten Lage reicht.

Die Spulenanordnung 10 kann in anderen Ausführungsbeispielen mit Spulen in einer anderen Reihenfolge und/oder mit verschiedenen größenmäßigen Verhältnissen der Spulen ausgebildet sein.

Der beschriebene Aufbau der Spulenanordnung auf einer Multilayer-Platine 1 erlaubt es zudem, weitere Spulen vorzusehen. Dabei können unterschiedliche Durchmesser und Windungsanzahlen vorgesehen sein, beispielsweise mit einem an die Platinengröße angepassten Wicklungsdurchmesser und/oder mit einer an die Dicke der Platine 1 angepassten Anzahl der Kupferlagen beziehungsweise der realisierten Windungen. Auch die Geometrien der Spulen können unterschiedlich ausgebildet werden.

Zudem können die Spulen 14, 16, 18 entlang ihrer Längsachse 19 praktisch beliebig zueinander positioniert werden, zumindest innerhalb der Dicke der Multilayer-Platine 1, sodass vorteilhafterweise die Einbaueigenschaften des Sensors durch die Lage der Spulen 14, 16, 18 optimiert werden können.

Mit Bezug zu Fig. 2 wird ein Ausführungsbeispiel eines induktiven Lagesensors mit der Spulenanordnung erläutert. Dabei wird von dem oben erläuterten Ausführungsbeispiel der Spulenanordnung 10 ausgegangen.

Der induktive Lagesensor 22 weist eine Spulenanordnung 26, die im Wesentlichen einer Spulenanordnung 10 gemäß dem oben erläuterten Ausführungsbeispiel entspricht.

Er weit ferner eine Steuereinheit 30 auf, die mit der Spulenanordnung 10 gekoppelt ist und diese so ansteuert, dass ein Eindringen oder eine Lageänderung eines Zielobjekts 28 in einem Erfassungsbereich 32 erfasst werden kann. Die Steuereinheit 30 ist dazu eingerichtet, in Abhängigkeit von dem erfassten Zielobjekt 28 ein Signal auszugeben, etwa ein Schaltsignal an eine weitere Einrichtung oder ein Signal an ein übergeordnetes Steuersystem.

Der induktive Lagesensor 22 weist bei dem Beispiel ein Gehäuse 24 auf, das beispielsweise aus Metall gebildet sein kann.

Die Spulenanordnung 26 ist bei dem Beispiel an die Querschnittsgeometrie des Gehäuses 24 angepasst.

Bei dem Beispiel ist ein kreisrunder Gehäusequerschnitt vorgesehen. Die Empfängerspulen 14, 18 der Spulenanordnung 26 sind hierbei quadratisch ausgebildet, sodass lediglich die Eckpunkte nahe am Gehäuse 24 angeordnet sind und die Seiten des Quadrats eher weiter von diesem entfernt sind. Hierdurch wird der Einfluss von Störungen des metallischen Gehäuses 24 auf die Erfassungsfähigkeit des Sensors 22 verringert.

Bei einem weiteren Beispiel kann ein quadratischer Gehäusequerschnitt vorgesehen sein. Ebenfalls quadratisch ausgebildete Empfängerspulen 14, 18 der Spulenanordnung 26 sind 45° relativ zur Geometrie des Gehäusequerschnitts gedreht, sodass die Ecken der Spulen 14, 18 nahe an den Seitenflächen des quadratischen Gehäusequerschnitts angeordnet sind, während die Seiten der Spulen 14, 18 weiter von den Ecken des Gehäusequerschnitts entfernt sind. Auch auf diese Weise werden Störungen durch das metallische Gehäusematerial vermieden.

Mit Bezug zu Fig. 4 wird anhand eines Flussdiagramms ein Ausführungsbeispiel des Verfahrens zum Herstellen einer Spulenanordnung erläutert.

Das Verfahren 400 umfasst einen ersten Schritt 401, einen zweiten Schritt 402 und einen dritten Schritt 403.

Bei dem ersten Schritt 401 wird eine erste Spule 16 erstellt. Die erste Spule 16 weist zumindest zwei Windungen 161 bis 168 auf, wobei die Windungen 161 bis 168 der ersten Spule 16 übereinander in separaten Lagen 101 bis 114 einer Multilayer-Platine 1 angeordnet sind und einen gemeinsamen ersten Durchmesser D1 aufweisen.

Bei dem zweiten Schritt 402 wird eine zweite Spule 14 erstellt. Die zweite Spule 14 weist zumindest zwei Windungen 141 bis 148 auf, wobei die Windungen 141 bis 148 der zweiten Spule 14 übereinander in separaten Lagen 101 bis 114 der Multilayer-Platine 1 angeordnet sind und einen gemeinsamen zweiten Durchmesser D2 aufweisen.

Bei dem dritten Schritt 403 wird eine dritte Spule 18 erstellt. Die dritte Spule 18 weist zumindest zwei Windungen 181 bis 188 auf, wobei die Windungen 181 bis 188 der dritten Spule 18 übereinander in separaten Lagen 101 bis 114 der Multilayer-Platine 1 angeordnet sind und einen gemeinsamen dritten Durchmesser D3 aufweisen.

Die Windungen 161 bis 168 der ersten Spule 16, die Windungen 141 bis 148 der zweiten Spule 14 und/oder die Windungen 181 bis 188 der dritten Spule 18 sind zumindest teilweise in der gleichen Lage der Multilayer-Platine 1 angeordnet.

Sämtliche Windungen 161 bis 168 der ersten Spule 16 sind als vollständige Windungen in jeweils einer einzigen Ebene ausgebildet.

Sämtliche Windungen 141 bis 148 der zweiten Spule 14 sind als vollständige Windungen in jeweils einer einzigen Ebene ausgebildet.

Sämtliche Windungen 181 bis 188 der dritten Spule 18 sind als vollständige Windungen in jeweils einer einzigen Ebene ausgebildet.

Auch wenn das Verfahren 400 mit drei Schritten 401, 402, 403 beschrieben wurde, können die Schritte auch gleichzeitig ausgeführt werden. Beispielsweise kann die Multilayer-Platine 1 Schicht für Schicht 101 bis 114 hergestellt werden.

Eine wesentliche Idee der vorliegenden Beschreibung liegt darin, dass bei der Spulenanordnung mit zumindest zwei Spulen die einzelnen Windungen der ersten Spule alle einen ersten Durchmesser haben und dass die Windungen der zweiten Spule alle einen zweiten Durchmesser haben. Indem die Windungen der Spulen in jeweils zueinander benachbarten Lagen der Multilayer-Platine platziert werden, insbesondere mit einer gemeinsamen Längsachse, werden daher zylindrische Spulen auf einer Multilayer-Platine ausgebildet. Zumindest eine der Windungen der ersten Spule und zumindest eine der Windungen der zweiten Spule sind in der gleichen Lage der Multilayer-Platine angeordnet, das heißt, die Erstreckung der ersten und zweiten Spule in Längsrichtung überlappen einander beziehungsweise die eine Spule ist zumindest teilweise innerhalb der anderen angeordnet.

### Bezugszeichenliste

- 1: Multilayer-Platine
- 101 bis 114: Schichten der Multilayer-Platine
- 10: Spulenanordnung
- 12: Abschirmgitter
- 14: Zweite Spule (Empfängerspule groß)
- 141 bis 148: Windungen (zweite Spule)
- 15: Durchkontaktierung (zum Verbinden von Windungen der zweiten Spule)
- 16: Erste Spule (Sendespule)
- 161 bis 168: Windungen (erste Spule)
- 17: Durchkontaktierung (zum Verbinden von Windungen der ersten Spule)
- 18: Dritte Spule (Empfangsspule klein)
- 181 bis 188: Windungen (dritte Spule)
- 19: Längsachse
- 20: Elektrische Kontaktierung
- 22: Induktiver Lagesensor
- 24: Sensorgehäuse
- 26: Spulenanordnung
- 28: Zielobjekt
- 30: Steuereinheit
- 32: Erfassungsbereich
- D1: Erster gemeinsamer Durchmesser (erste Spule)
- D2: Zweiter gemeinsamer Durchmesser (zweite Spule)
- D3: Dritter gemeinsamer Durchmesser (dritte Spule)

## Patentansprüche

1. Multilayer-Platine (1) mit einer Spulenanordnung (10), insbesondere für einen induktiven Lagesensor (22); die Spulenanordnung (10) umfassend
eine erste Spule (16) mit zumindest zwei Windungen, wobei die Windungen der ersten Spule (16) in separaten Lagen der Multilayer-Platine (1) übereinander angeordnet sind und einen gemeinsamen ersten Durchmesser (D1) aufweisen; und
eine zweite Spule (14) mit zumindest zwei Windungen, wobei die Windungen der zweiten Spule (14) in separaten Lagen der Multilayer-Platine (1) übereinander angeordnet sind und einen gemeinsamen zweiten Durchmesser (D2) aufweisen; wobei
die Windungen der ersten Spule (16) und die Windungen der zweiten Spule (14) zumindest teilweise in den gleichen Lagen der Multilayer-Platine (1) angeordnet sind; wobei
sämtliche Windungen der ersten Spule (16) im Wesentlichen vollständig in jeweils einer Lage der Multilayer-Platine (1) ausgebildet sind; und wobei
sämtliche Windungen der zweiten Spule (14) im Wesentlichen vollständig in jeweils einer Lage der Multilayer-Platine (1) ausgebildet sind.

2. Multilayer-Platine (1) gemäß Anspruch 1,
**dadurch gekennzeichnet, dass**
die erste (16) und die zweite Spule (14) eine gemeinsame Längsachse aufweisen.

3. Multilayer-Platine (1) gemäß einem der vorhergehenden Ansprüche,
**dadurch gekennzeichnet, dass**
die erste (16) und die zweite Spule (14) als Zylinderspulen ausgebildet sind, wobei sich die Erstreckung der ersten (16) und zweiten Spule (14) in Längsrichtung überlappen, sodass eine Spule (16, 14) zumindest teilweise innerhalb der anderen Spule (14, 16) angeordnet ist.

4. Multilayer-Platine (1) gemäß einem der vorhergehenden Ansprüche,
**gekennzeichnet durch**
eine dritte Spule (18) mit zumindest zwei Windungen, wobei die Windungen der dritten Spule (18) in separaten Lagen der Multilayer-Platine (1) übereinander angeordnet sind und einen gemeinsamen ersten Durchmesser (D3) aufweisen; wobei
die Windungen der dritten Spule (18) und die Windungen der ersten (16) und/oder zweiten Spule (14) zumindest teilweise in den gleichen Lagen der Multilayer-Platine (1) angeordnet sind; wobei
sämtliche Windungen der dritten Spule (18) im Wesentlichen vollständig in jeweils einer Lage der Multilayer-Platine (1) ausgebildet sind.

5. Multilayer-Platine (1) gemäß einem der vorhergehenden Ansprüche,
**dadurch gekennzeichnet, dass**
die erste (16), zweite (14) und/oder gegebenenfalls dritte Spule (18) so ausgebildet sind, dass die aufeinander folgenden Windungen einer Spule (14, 16, 18) in jeweils aufeinander folgenden Schichten der Multilayer-Platine ausgebildet sind.

6. Multilayer-Platine (1) gemäß einem der vorhergehenden Ansprüche,
**dadurch gekennzeichnet, dass**
sämtliche Windungen der ersten (16), zweiten (14) und/oder gegebenenfalls der dritten Spule (18) als jeweils im Wesentlichen vollständige Windungen in jeweils einer Lage der Multilayer-Platine (1) ausgebildet sind.

7. Multilayer-Platine (1) gemäß einem der vorhergehenden Ansprüche,
**dadurch gekennzeichnet, dass**
zumindest eine der ersten (16) und/oder zweiten (14) und/oder gegebenenfalls der dritten Spule (18) eine polygonale Geometrie aufweist.

8. Multilayer-Platine (1) gemäß einem der vorhergehenden Ansprüche,
**dadurch gekennzeichnet, dass**
zumindest ein Teil der Windungen der ersten (16) und zweiten Spule (14), sowie gegebenenfalls der dritten Spule (18), in überlappenden Lagen der Multilayer-Platine angeordnet sind; wobei
optional in zumindest einer Lage der Multilayer-Platine jeweils eine Windung aller Spulen (14, 16, 18) angeordnet sind.

9. Induktiver Lagesensor (22) mit einer Spulenanordnung (26) gemäß einem der vorhergehenden Ansprüche.

10. Verfahren zum Herstellen einer Spulenanordnung (10), insbesondere für einen induktiven Lagesensor (22); wobei
eine erste Spule (16) mit zumindest zwei Windungen so erstellt wird, dass die Windungen der ersten Spule (16) in separaten Lagen einer Multilayer-Platine (1) übereinander angeordnet sind und einen gemeinsamen ersten Durchmesser (D1) aufweisen; und
eine zweite Spule (14) mit zumindest zwei Windungen so erstellt wird, dass die Windungen in separaten Lagen der Multilayer-Platine (1) übereinander angeordnet sind und einen gemeinsamen zweiten Durchmesser (D2) aufweisen; wobei
die Windungen der ersten Spule (16) und die Windungen der zweiten Spule (14) zumindest teilweise in den gleichen Lagen der Multilayer-Platine angeordnet sind; wobei
sämtliche Windungen der ersten Spule (16) im Wesentlichen vollständig in jeweils einer Lage der Multilayer-Platine (1) ausgebildet sind; und wobei
sämtliche Windungen der zweiten Spule (14) im Wesentlichen vollständig in jeweils einer Lage der Multilayer-Platine (1) ausgebildet sind.
